# EUROPÄISCHE PATENTSCHRIFT

(11) **EP 3 613 269 B1**
(45) Veröffentlichungstag und Bekanntmachung des Hinweises auf die Patenterteilung: **16.12.2020**
(21) Anmeldenummer: 18719533.4
(22) Anmeldetag: 20.04.2018
(51) Int. Cl.: H05K 9/00, H05K 7/20

(54) **GEHÄUSE FÜR EIN ELEKTRISCHES ODER ELEKTRONISCHES GERÄT**
HOUSING FOR AN ELECTRIC OR ELECTRONIC DEVICE
BOÎTIER POUR UN APPAREIL ÉLECTRIQUE OU ÉLECTRONIQUE

(30) Priorität: 20.04.2017 DE 102017003854
(43) Veröffentlichungstag der Anmeldung: 26.02.2020
(73) Patentinhaber: KOSTAL Automobil Elektrik GmbH & Co. KG, 58513 Lüdenscheid (DE)
(72) Erfinder: ESDERS, Berthold, 58579 Schalksmühle (DE); PÜHL, Thorsten, 58769 Nachrodt-Wiblingwerde (DE); THIEL, Matthias, 58511 Lüdenscheid (DE); RIEDEL, Rene, 45529 Hattingen (DE)
(74) Vertreter: Kerkmann, Detlef
(86) Internationale Anmeldenummer: PCT/EP2018/060164
(87) Internationale Veröffentlichungsnummer: WO 2018/193081

(56) Entgegenhaltungen:
- EP-A1- 2 625 938
- DE-A1-102015 107 306
- DE-B3-102005 001 148
- DE-T5-112006 002 637
- DE-U1-202014 105 179
- US-A1- 2002 180 108
- US-A1- 2011 261 531

## Beschreibung

Die Erfindung betrifft ein Gehäuse für ein elektrisches oder elektronisches Gerät, mit einem topfförmigen Gehäusemantel aus Kunststoff, mit wenigstens einem in dem Gehäusemantel geführten Kühlkanal zur Fluidkühlung des Geräts, wobei ein flächenhafter Abschirmkörper zur Abschirmung elektromagnetischer Strahlung in den Gehäusemantel integriert ist, welcher die Wände des Gehäusemantels durchzieht.

Solche Gehäuse werden insbesondere für elektrische oder elektronische Geräte vorgesehen, die intern hohe elektrische Leistungen verarbeiten, wie beispielsweise Ladegeräte oder Leistungswandler für elektrisch angetriebene Fahrzeuge. Die unvermeidlich auftretenden erheblichen Verlustleistungen solcher Geräte erfordern eine gute Wärmeabfuhr oder sogar eine aktive Kühlung.

Durchaus üblich ist es, siehe zum Beispiel US 2011/261531, Gehäuse aus einem gut wärmeleitenden Metall wie beispielsweise Aluminiumdruckguss zu fertigen, bei denen der Gehäusekörper als Kühlkörper und die Gehäuseoberfläche als Wärmeabstrahlfläche genutzt werden kann. Solche Gehäuse haben zugleich den Vorteil, eine gute elektromagnetische Abschirmung sowohl nach außen als auch nach innen zu ermöglichen. Leider ist die Fertigung solcher Gehäuse durch hohe Materialkosten und eine aufwendige Bearbeitung relativ kostenaufwendig.

Bevorzugt werden daher oftmals Kunststoffgehäuse, auch wenn diese aktive Kühlmaßnahmen erfordern. Bekannt ist es, Kunststoffgehäuse mit an- oder eingeformten Rohrleitungen zu versehen, durch die eine Kühlflüssigkeit hindurchgeleitet werden kann. Auch zur elektromagnetischen Abschirmung können Maßnahmen vorgesehen werden, wie in das Kunststoffgehäuse eingebrachte metallene Abschirmflächen, die durch Metallfolien, Metallbleche oder Metallgewebematten realisiert sein können.

So ist aus der deutschen Offenlegungsschrift DE 10 2015 205 591 A1 ein flüssigkeitsgekühlter Gehäusemantel für eine elektrische Maschine bekannt. Der topfförmige Gehäusemantel besteht aus einem Kunststoff, wobei an einem Außenumfang des Gehäusemantels wenigstens ein Kühlkanal zur Fluidkühlung der elektrischen Maschine innerhalb des Gehäusemantels angeformt ist. Zwischen einer Innenfläche des Gehäusemantels und dem Kühlkanal ist eine Gewebelage in den Gehäusemantel integriert, welche den Gehäusemantel durchzieht. Die Gewebelage kann auch aus einem Metallgewebe bestehen und dadurch elektromagnetische Strahlung abschirmen.

Durch die vorgesehenen Maßnahmen zur Kühlung und elektromagnetischen Abschirmung, weist das vorgeschlagene Kunststoffgehäuse eine komplexe Form auf, deren Herstellung immer noch relativ hohe Kosten verursachen kann.

Aus den Dokumenten DE 10 2005 001148, EP 2 625 938, DE 20 2014 105179, DE 10 2015 107306, DE 11 2006 002637 und US 2002/180108 sind auch andere Gehäuse mit Kühlung und/oder Abschirmung von elektrischen oder elektronischen Geräten bekannt.

Es stellte sich die Aufgabe, ein derartiges Gehäuse für ein elektrisches oder elektronisches Gerät mit einem Gehäusekörper aus einem Kunststoff so auszubilden, dass es auf besonders einfache und kostengünstige Weise herstellbar ist.

Diese Aufgabe wird erfindungsgemäß dadurch gelöst, dass der

Abschirmkörper als ein Drahtkäfig oder eine Metallwanne ausgebildet ist, dass der Kühlkanal durch ein Metallrohr ausgebildet ist, dass der Abschirmkörper und der Kühlkanal zu einer vormontierten Anordnung verbunden sind, und dass die vormontierte Anordnung aus Abschirmkörper und Kühlkanal zur Ausbildung des Gehäusemantels mit einem Kunststoff umspritzt oder in einen Kunststoff eingegossen ist.

Die erfindungsgemäße Ausgestaltung des Gehäuses sieht somit vor, metallene Komponenten zur Kühlung und zur elektromagnetischen Abschirmung des elektrischen oder elektronischen Geräts zu einer gerüstartigen Anordnung vorzumontieren und anschließend, vorzugsweise in einem einzigen Prozessschritt, mit einem Gehäusemantel aus Kunststoff zu umgeben. Speziell wird ein Umspritzen oder ein Umspülen der vormontierten Anordnung mit einem aushärtenden Kunststoff vorgeschlagen.

Besonders vorteilhaft ist, dass die Herstellung des Gehäusemantels aus Kunststoff keine komplexen Bearbeitungsschritte erfordert, wie sie etwa zur Einformung von gewundenen Kühlkanälen in einen Gehäusemantel erforderlich wären.

Ebenfalls sehr vorteilhaft ist, dass sowohl der Abschirmkörper als auch der Kühlkanal aus Metall bestehen und nach der Vormontage einen einzigen Metallkörper mit einer relativ hohen Wärmekapazität bilden.

Vorteilhaft ist auch, dass durch einfaches Biegen eines Metallrohrs die Form des Kühlkanals sehr flexibel angepasst werden kann.

Vorteilhaft ist es, eine niedrigviskose Kunststoffmasse zum Umspülen der vormontierten Anordnung vorzusehen. Ein solcher Prozess kann mit geringen Drücken durchgeführt werden, durch die auch die Verwendung dünnwandiger Materialien zur Ausbildung der vormontierten Anordnung möglich wird.

Zur Verbesserung der Wärmeableitung kann eine thermisch gut leitfähige niedrigviskose Masse als Umspülungsmaterial oder ein thermisch gut leitfähiges Material als Füllstoff eines aushärtenden Kunststoffs vorgesehen werden.

Der Abschirmkörper kann durch ein mehr oder weniger dünnes Metallblech oder auch durch eine Metallfolie hergestellt werden, die recht einfach in die vorgesehene Form gebracht werden kann. Alternativ kann auch die Verwendung eines tiefgezogenen Metallhohlkörpers oder von gestanzt gebogenen Blechen vorgesehen werden.

Die Vormontage der Anordnung aus Kühlkanal und Abschirmkörper kann sehr einfach mittels nicht lösbarer oder auch lösbarer Verbindungen erfolgen, also etwa durch Löten oder Schweißen oder auch mittels Schrauben oder Klemmen.

Vorteilhafterweise können zusätzliche Kühlelemente als Bestandteile der vormontierten Anordnung vorgesehen werden, die sich nach Fertigstellung des Gehäusemantels abschnittsweise bis in das Innere des Gehäuses erstrecken und dort Kühlkörper für elektrische oder elektronische Bauteile ausbilden. Zusätzlich können die Kühlelemente auch als Befestigungsmittel, etwas als Anschraubflächen, für Komponenten des Geräts im Innenraum des Gehäuses dienen.

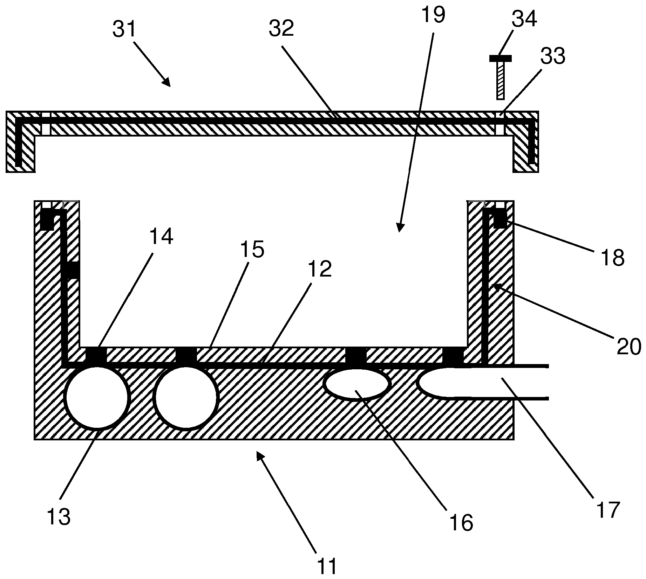

Eine Rundumabschirmung kann leicht dadurch realisiert werden, dass das topfförmige Gehäuse durch einen Kunststoffdeckel abgeschlossen wird, welcher eine eingeformte Abschirmfläche aufweist. Dieser kann sehr einfach und kostengünstig durch eine Metallfolie ausgebildet sein.
Nachfolgend soll die Erfindung anhand der beigefügten Zeichnung näher erläutert werden. Die einzige Figur zeigt eine schematische Querschnittsansicht durch ein erfindungsgemäß ausgeführtes Gehäuse für ein elektrisches oder elektronisches Gerät.

Das Gehäuse weist einen topfförmigen Gehäusemantel 11 aus Kunststoff auf, der eine vormontierte Anordnung 20 aus diversen metallenen Komponenten 12, 13, 14 umschließt.

Zu diesen Komponenten gehört ein metallener Abschirmkörper 12, der flächenhaft ausgebildet ist, was besagt, dass im Verhältnis zur Ausdehnung seiner Oberflächen sein Materialvolumen relativ gering ist. Vorzugsweise besteht er aus einem dünnen Metallblech, aus einer Metallfolie oder aus einem Drahtgitter. Das Material des Abschirmkörpers 12 ist zu einem muldenförmigen Gegenstand geformt, dessen Form im Wesentlichen der Form des ihn einschließenden topfförmigen Gehäusemantels 11 entspricht.

Mit dem Abschirmkörper 12 verbunden ist mindestens ein durch ein Metallrohr gebildeter Kühlkanal 13, der innerhalb des Gehäusemantels 11 eine mehrfach abgewinkelte und beispielsweise mäanderförmige Form ausbildet.

Der Abschirmkörper 12 und der Kühlkanal 13 können aus Stahllegierungen oder auch besonders vorteilhaft aus gut temperaturleitfähigen Werkstoffen, wie zum Beispiel Kupfer oder Aluminium hergestellt sein.

Wenigstens zwei Endabschnitte des Kühlkanals 13 sind als Zulaufleitung 16 und Ablaufleitung 17 durch eine Außenwand des Gehäusemantels 11 hindurchgeführt. Hierdurch ist es möglich, eine Durchflusskühlung des Gehäusemantels 11 mittels eines von außen eingespeisten Kühlfluids, das beispielsweise aus Wasser oder Öl besteht, vorzusehen.

Durch die mechanische Verbindung des Abschirmkörpers 12 und des durch die gewundene Rohrleitung gebildeten Kühlkanals 13 stabilisieren sich diese Komponenten gegenseitig zu einer vormontierten Anordnung 20. Die mechanische Verbindung zwischen dem Abschirmkörper 12 und dem Kühlkanal 13 kann entweder als nicht lösbare Verbindung durch Löten oder Schweißen oder auch durch lösbare Verbindungsmittel, wie beispielsweise anschraubbare Rohrschellen hergestellt werden. Die Verbindungsmittel werden bevorzugt so gewählt, dass sie neben einer stabilen mechanischen Verbindung auch eine gute thermische Kopplung der miteinander verbundenen Komponenten 12, 13 gewährleisten.

Zur vormontierten Anordnung 20 können auch Kühlelemente 14 gehören, die nach Fertigstellung des Gehäusemantels 11 in den durch den Gehäusemantel 11 gebildeten Innenraum 15 des Gehäuses reichen, so dass die zu kühlenden elektrischen und/oder elektronischen Bauelemente (in der Figur nicht dargestellt) mit diesen Kühlelementen 14 mechanisch und thermisch verbunden werden können. Die Kühlelemente 14 dienen daher vorteilhaft zugleich als Wärmeableiter wie auch als Befestigungselemente.

Da die Kühlelemente 14 thermisch mit dem Abschirmkörper 12 und/oder mit dem Kühlkanal 13 gekoppelt sind, wird die von den kühlenden elektrischen und/oder elektronischen Bauelementen erzeugte Wärme über die Komponenten 12, 13, 14 der vormontierten Anordnung 20 letztendlich an das durch der Kühlkanal 13 fließende Kühlfluid abgegeben.

Nach Fertigstellung der Anordnung 20 wird diese mit einem Kunststoffmaterial umspritzt oder umspült, wozu die vormontierte Anordnung 20 temporär in eine Hohlform eingesetzt wird. Wie die Figur zeigt, wird dabei der Kühlkanal 13, bis auf Endabschnitte, die die Zulauf- und die Ablaufleitung 16, 17 bilden, vollständig von dem Kunststoffmaterial umschlossen.
Als Kunststoffmaterial wird bevorzugt eine niedrigviskose Masse vorgesehen, welche durch eine exotherme Reaktion aushärtet. Hierzu geeignete Materialien finden sich besonders in den Stoffgruppen der Polyurethane, Polyharnstoffe (Polyurea) und anderer Duroplastwerkstoffe.

Der im Gehäusemantel 11 eingeschlossene Abschirmkörper 12 ist so ausgebildet, dass seine Flächen alle vier Wände und die Bodenfläche des Gehäusemantels 11 durchziehen. Die Bauteile des innerhalb des topfförmigen Gehäusemantels 11 angeordneten Geräts sind somit von fünf Seiten von in Kunststoff eingeschlossenen metallenen Flächen des Abschirmkörpers 12 umgeben.

Durch Anfügen eines Gehäusedeckels 31 kann der vom Gehäusemantel 11 gebildete Innenraum 15 abgeschlossen werden. Vorteilhafterweise weist der Gehäusedeckel 31 eine Abschirmfläche 32 auf, die bevorzugt durch eine in Kunststoff eingeschlossene Metallfolie gebildet sein kann. Durch Anfügen des Gehäusedeckels 31 an den Gehäusemantel 11 wird der von einer Seite offene Abschirmkörper 12 zu einer geschlossenen Abschirmhülle, in seiner Funktion einem faradayschen Käfig entsprechend, ergänzt.

Vorteilhaft ist es, durch metallene Verbindungselemente die Abschirmfläche 32 auch elektrisch mit dem Abschirmkörper 12 zu verbinden. Hierzu können beispielsweise Metallschrauben 34 in Schrauböffnungen 33 des Gehäusedeckels 31 eingesetzt werden und mit metallenen Anschraubelementen 18 im Gehäusemantel 11 verbunden werden, welche in elektrischer Verbindung zum Abschirmkörper 12 stehen. Da die Metallschrauben 34 die Abschirmfläche 32 auch elektrisch kontaktieren, stellen sie so auch die elektrische Verbindung zwischen der Abschirmfläche 32 und dem Abschirmkörper 12 her.

Erzielt wird so eine gute Abschirmung des Innenraums 15 hinsichtlich nicht erwünschter Ein- wie auch Abstrahlungen elektromagnetischer Strahlung.

Dabei ist es vorteilhaft, wenn, wie in der Figur skizziert, der Gehäusedeckel 31 den Gehäusemantel 11 und ebenso die Abschirmfläche 32 den Abschirmkörper 12 nicht nur abdeckt sondern ein Stück weit überlappt.

Das so gebildete Gehäuse erreicht mit einem vergleichsweise geringen Kostenaufwand eine gute Kühl- und elektromagnetische Abschirmwirkung, dies sonst nur mit wesentlich teureren Metallgehäusen erreichbar sind. Des Weiteren wird eine vorteilhafte Gewichtsreduktion durch Verwendung von Materialien mit niedrigerer Dichte gegenüber beispielsweise Aluminium erreicht.

### Bezugszeichen

- 11: Gehäusemantel
- 12: Abschirmkörper
- 13: Kühlkanal
- 14: Kühlelemente
- 12, 13, 14: metallene Komponenten
- 15: Innenraum
- 16: Zulaufleitung
- 17: Ablaufleitung
- 18: Anschraubelemente
- 19: Innenraum
- 20: (vormontierte) Anordnung
- 31: Gehäusedeckel
- 32: Abschirmfläche
- 33: Schrauböffnungen
- 34: Metallschrauben

## Patentansprüche

1. Gehäuse für ein elektrisches oder elektronisches Gerät,
mit einem topfförmigen Gehäusemantel (11) aus Kunststoff,
mit wenigstens einem in dem Gehäusemantel (11) geführten Kühlkanal (13) zur Fluidkühlung des Geräts,
wobei ein flächenhafter Abschirmkörper (12) zur Abschirmung elektromagnetischer Strahlung in den Gehäusemantel (11) integriert ist, welcher die Wände des Gehäusemantels (11) durchzieht,
**dadurch gekennzeichnet,**
**dass** der Abschirmkörper (12) als ein Drahtkäfig oder eine Metallwanne ausgebildet ist,
**dass** der Kühlkanal (13) durch ein Metallrohr ausgebildet ist,
**dass** der Abschirmkörper (12) und der Kühlkanal (13) zu einer vormontierten Anordnung (20) verbunden sind, und
**dass** die vormontierte Anordnung (20) aus Abschirmkörper (12) und Kühlkanal (13) zur Ausbildung des Gehäusemantels (11) mit einem Kunststoff umspritzt oder in einen Kunststoff eingegossen ist.

2. Gehäuse nach Anspruch 1, **dadurch gekennzeichnet, dass** mit der vormontierten Anordnung (20) Kühlelemente (14) verbunden sind, die sich bis mindestens zu den Flächen des Innenraums (15) des Gehäusemantels (11) erstrecken.

3. Gehäuse nach Anspruch 2, **dadurch gekennzeichnet, dass** die Kühlelemente (14) zugleich Befestigungsmittel für im Innenraum (15) des Gehäusemantels (11) angeordnete Komponenten des Geräts ausbilden.

4. Gehäuse nach Anspruch 1, **dadurch gekennzeichnet, dass** der Innenraum (15) des topfförmigen Gehäusemantels (11) durch einen Gehäusedeckel (31) abschließbar ist, wobei der Gehäusedeckel (31) eine metallene Abschirmfläche (32) enthält.

5. Gehäuse nach Anspruch 4, **dadurch gekennzeichnet, dass** der Abschirmkörper (12) des Gehäusemantels (11) und die Abschirmfläche (32) des Gehäusedeckels (31) elektrisch miteinander verbindbar sind.

6. Gehäuse nach Anspruch 1, **dadurch gekennzeichnet, dass** der Kühlkanal (13) aus dem Gehäusemantel (11) herausgeführte Zulauf- (16) und Ablaufleitungen (17) aufweist.

7. Gehäuse nach Anspruch 1, **dadurch gekennzeichnet, dass** der Kühlkanal (13) innerhalb des Gehäusemantels (11) mehrfach abgewinkelt geformt ist.

8. Gehäuse nach Anspruch 1, **dadurch gekennzeichnet, dass** zur Herstellung des Gehäusemantels (11) die vormontierte Anordnung (20) mit einer niedrigviskosen Masse umspült wird, welche unter Wärmeabgabe aushärtet.

9. Gehäuse nach Anspruch 8, **dadurch gekennzeichnet, dass** die niedrigviskose Masse nach dem Aushärten einen Körper aus einem Duroplastwerkstoff, insbesondere aus einem Polyurethan oder einem Polyharnstoff ausbildet.

10. Gehäuse nach Anspruch 8, **dadurch gekennzeichnet, dass** die niedrigviskose Masse zur besseren thermischen Leitfähigkeit mit gut wärmeleitenden Füllstoffen versehen ist.

## Claims

1. Housing for an electrical or electronic device,
with a pot-shaped housing jacket (11) made of plastic,
with at least one cooling channel (13) guided in the housing jacket (11) for fluid cooling of the device,
wherein a flat shielding body (12) for shielding electromagnetic radiation is integrated into the housing jacket (11), which passes through the walls of the housing jacket (11),
**characterized by** this,
that the shielding body (12) is formed as a wire cage or a metal trough,
that the cooling channel (13) is formed by a metal tube,
in that the shielding body (12) and the cooling channel (13) are connected to form a pre-assembled arrangement (20), and
in that the pre-assembled arrangement (20) comprising the screening body (12) and cooling channel (13) is injection-moulded around with a plastic material or is cast into a plastic material in order to form the housing jacket (11).

2. Housing according to claim 1, **characterized in that** cooling elements (14) are connected to the pre-assembled arrangement (20), which cooling elements (14) extend at least up to the surfaces of the interior (15) of the housing jacket (11).

3. Housing according to claim 2, **characterized in that** the cooling elements (14) at the same time form fastening means for components of the device arranged in the interior (15) of the housing jacket (11).

4. Housing according to claim 1, **characterized in that** the interior (15) of the pot-shaped housing jacket (11) can be closed off by a housing cover (31), the housing cover (31) containing a metal shielding surface (32).

5. Housing according to claim 4, **characterized in that** the shielding body (12) of the housing jacket (11) and the shielding surface (32) of the housing cover (31) are electrically connectable to each other.

6. Housing according to claim 1, **characterized in that** the cooling channel (13) has inlet (16) and outlet (17) lines which lead out of the housing jacket (11).

7. The housing according to claim 1, **characterized in that** the cooling channel (13) within the housing jacket (11) is formed with multiple angles.

8. Housing according to claim 1, **characterized in that**, in order to produce the housing jacket (11), the pre-assembled arrangement (20) is surrounded by a low-viscosity mass which hardens with the release of heat.

9. Housing according to claim 8, **characterized in that** the low-viscosity mass, after curing, forms a body of a thermoset material, in particular of a polyurethane or a polyurea.

10. Housing according to claim 8, **characterized in that** the low-viscosity mass is provided with fillers with good thermal conductivity for better thermal conductivity.

## Revendications

1. Boitier pour un appareil électrique ou électronique
avec un carter de boitier (11) en forme de pot, réalisé en matière synthétique, avec au moins un canal de refroidissement (13), qui, s'étendant dans le carter de boitier (11), est prévu pour le refroidissement de l'appareil au moyen d'un fluide,
sachant qu'un corps d'écran (12), qui parcourt les parois du carter de boitier (11), est intégré dans le carter de boitier (11) pour la protection contre les rayonnements électromagnétiques,
**caractérisé en ce que**
le corps d'écran (12) est réalisé sous la forme d'une cage grillagée ou d'une cuvette métallique,
le canal de refroidissement (13) est formé par un tube métallique,
le corps d'écran (12) et le canal de refroidissement (13) sont reliés ensemble en un arrangement prémonté (20), et
l'arrangement prémonté (20), formé par le corps d'écran (12) et le canal de refroidissement (13), est surmoulé ou coulé en matière synthétique pour former le carter de boitier (11).

2. Boitier selon la revendication 1, **caractérisé en ce que** des éléments de refroidissement (14), qui s'étendent au moins jusqu'aux faces de l'espace intérieur (15) du carter de boitier (11), sont reliés à l'arrangement prémonté (20).

3. Boitier selon la revendication 2, **caractérisé en ce que** les éléments de refroidissement (14) forment simultanément des moyens de fixation pour les composants de l'appareil disposés dans l'espace intérieur (15) du carter de boitier (11).

4. Boitier selon la revendication 1, **caractérisé en ce que** l'espace intérieur (15) du carter de boitier (11) en forme de pot peut être fermé par un couvercle de boitier (31), sachant que le couvercle de boitier (31) comprend une face d'écran métallique (32).

5. Boitier selon la revendication 4, **caractérisé en ce que** le corps d'écran (12) du carter de boitier (11) et la face d'écran (32) du couvercle de boitier (31) peuvent être connectés ensemble électriquement.

6. Boitier selon la revendication 1, **caractérisé en ce que** le canal de refroidissement (13) présente des conduites d'admission (16) et d'évacuation (17) partant du carter de boitier (11).

7. Boitier selon la revendication 1, **caractérisé en ce que** le canal de refroidissement (13) est formé à l'intérieur du carter de boitier (11) en étant coudé plusieurs fois.

8. Boitier selon la revendication 1, **caractérisé en ce que**, pour la fabrication du carter de boitier (11), l'arrangement prémonté (20) est baigné dans une masse à faible viscosité, qui durcit sous l'effet de la chaleur délivrée.

9. Boitier selon la revendication 8, **caractérisé en ce que** la masse à faible viscosité forme, après le durcissement, un corps en matériau thermodurcissable, en particulier en polyuréthane ou en polyurée.

10. Boitier selon la revendication 8, **caractérisé en ce que** la masse à faible viscosité présente des matériaux de remplissage conducteurs thermiques assurant une meilleure conductibilité thermique.
